# FASCICULE DE BREVET EUROPEEN

(11) **EP 2 502 472 B1**
(45) Date de publication et mention de la délivrance du brevet: **31.05.2017**
(21) Numéro de dépôt: 10781678.7
(22) Date de dépôt: 19.11.2010
(51) Int. Cl.: H05K 7/20

(54) **DISPOSITIF DE DISSIPATION THERMIQUE, NOTAMMENT POUR COMPOSANTS VERTICAUX ET/OU DE FORME COMPLEXE**
WÄRMEABLEITUNGSVORRICHTUNG, IM BESONDEREN FÜR VERTIKALE KOMPONENTEN UND/ODER KOMPONENTEN MIT KOMPLEXER FORM
HEAT DISSIPATION DEVICE, IN PARTICULAR FOR COMPONENTS WHICH ARE VERTICAL AND/OR OF COMPLEX SHAPE

(30) Priorité: 20.11.2009 FR 0905590
(43) Date de publication de la demande: 26.09.2012
(73) Titulaire: Thales, 92400 Courbevoie (FR)
(72) Inventeur: BORRAT-MICHAUD, Pierre, F-49100 Angers (FR); TALLEC, Anne-Gaëlle, F-49300 Cholet (FR)
(74) Mandataire: Collet, Alain
(86) Numéro de dépôt international: PCT/EP2010/067865
(87) Numéro de publication internationale: WO 2011/061312

(56) Documents cités:
- GB-A- 1 202 220
- US-A1- 2004 070 946
- US-B1- 6 882 041

## Description

La présente invention concerne un dispositif de dissipation thermique, notamment pour des composants verticaux et/ou de forme complexe. Elle s'applique notamment au domaine de l'électronique, et plus particulièrement au domaine des cartes électroniques imprimées sur lesquelles sont montés des composants discrets.

De nombreux systèmes comprennent des dispositifs électroniques, se présentant par exemple sous la forme de cartes de circuit électronique au sein desquelles peuvent être intégrés des composants et/ou en surface desquelles des composants discrets peuvent être disposés. De telles cartes sont par exemple connues sous le sigle de "PCB" correspondant à la terminologie anglaise "Printed Circuit Board". Les cartes de circuit électronique peuvent être conçues pour des applications spécifiques et être ainsi dédiées à ces applications, mais peuvent également se présenter sous la forme de cartes disponibles dans le commerce et utilisables pour diverses applications.

D'une manière typique, les composants équipant des cartes de circuit électronique produisent lorsqu'ils sont mis en oeuvre, une certaine quantité de chaleur qui peut nuire au bon fonctionnement du système. Il est par conséquent nécessaire de concevoir un système électronique, de manière à maîtriser les phénomènes de production de chaleur induits au niveau des composants qu'il intègre, afin que les températures en fonctionnement n'atteignent jamais des valeurs critiques qui pourraient entraîner des pannes ou un mauvais fonctionnement. Il est également nécessaire de maîtriser les phénomènes de production et de dissipation thermique, afin que le fonctionnement du système soit garanti dans des plages de températures dont l'étendue varie en fonction des applications.

Notamment, des semi-conducteurs de puissance présentent en fonctionnement des pertes significatives produisant une chaleur intense. Pour de tels composants il est possible, selon des techniques en elles-mêmes connues de l'état de la technique, de recourir à des dispositifs de dissipation de chaleur. Il est par exemple possible d'utiliser des dissipateurs thermiques placés à proximité immédiate des composants produisant de la chaleur, parfois désignés "composants chauds". Un dissipateur thermique peut par exemple se présenter sous la forme d'une pièce réalisée en un matériau offrant des qualités d'absorption thermique, et par exemple muni d'ailettes. Il est également possible de recourir à une pâte thermique disposée entre le composant et le dispositif de dissipation thermique, dans le but d'assurer un contact optimal offrant une grande conductivité thermique. Cette technique présente l'inconvénient d'être peu adaptée à des composants disposés verticalement sur une carte électronique, ou bien des composants à forme complexe.

Une autre technique connue consiste à recourir à un ventilateur disposé à proximité du composant. Cette technique présente l'inconvénient de faire appel à des pièces mobiles, nécessitant une alimentation, produisant des nuisances sonores, et présentant une faible fiabilité.

Il est également possible de recourir à des dispositifs de refroidissement à effet Peltier offrant l'avantage de ne pas nécessiter de pièces mobiles et d'offrir un refroidissement efficace ; néanmoins de tels dispositifs présentent des inconvénients liés à la condensation, et sont plus spécifiquement appropriées pour le refroidissement de composants tels que les microprocesseurs.

Le brevet GB1202220 décrit un conditionnement modulaire pour circuit électronique de puissance comprenant une pluralité de parois conductrices électriquement et thermiquement. La résine utilisée dans ce document a un rôle de rigidification et de maintien de l'ensemble et non de dissipation de la température.

Le brevet US6882041 concerne un système de dissipation thermique dans un package BGA. Un capuchon métallique 100 comportant des orifices 102 vient se positionner au-dessus d'un composant 330 dont on souhaite dissiper la chaleur. Une partie de la cavité est remplie avec un matériau d'enrobage époxy thermique afin d'établir un trajet de conduction thermique entre le composant et le capuchon métallique.

Un but de la présente invention est de pallier au moins les inconvénients précités, en proposant un dispositif de dissipation thermique formant un système de drainage thermique par conduction de la chaleur via une résine offrant de bonnes propriétés thermiques, et enrobant le composant dont il est nécessaire de dissiper la chaleur.

Un avantage de l'invention est que le dispositif de dissipation thermique selon un des modes de réalisation de l'invention peut s'adapter à une grande diversité de composants, y compris des composants montés de manière verticale sur une carte de circuit électronique, ou encore des composants de forme complexe.

Un autre avantage de l'invention est qu'un système intégrant des dispositifs de dissipation thermique selon l'invention, présente une très bonne immunité, notamment vis-à-vis de chocs mécaniques ou de vibrations.

Encore un autre avantage de l'invention est qu'un composant associé à un dispositif de dissipation thermique selon un des modes de réalisation décrits, peut être facilement démonté, par exemple dans le cadre d'opérations de fabrication ou de maintenance du système dans lequel le composant s'intègre.

Encore un autre avantage de l'invention est qu'un dispositif de dissipation thermique selon un des modes de réalisation décrits, peut être adapté à des composants déjà présents sur des cartes électroniques.

A cet effet, l'invention a pour objet un ensemble de dissipation thermique, notamment pour composants montés sur une carte de circuit électronique, comprenant un dispositif de dissipation thermique, dans lequel :
- Le dispositif de dissipation thermique est un corps creux, de forme cylindrique ou prismatique droite, constitué d'un premier matériau, disposé verticalement au-dessus de la carte de circuit électronique, le volume utile du corps cylindrique incluant au moins le composant,
- Le dispositif de dissipation thermique contient une résine constituée d'un deuxième matériau, ayant une conductivité thermique supérieure à 1 W.m⁻¹.K⁻¹ et emplissant au moins partiellement le volume intérieur du corps formant coffrage et ledit composant étant enfoui au moins partiellement dans le volume de résine,
- Le corps comprend au moins deux pattes en sa partie supérieure, formées par des excroissances sur deux faces opposées du corps, les deux pattes comprenant une plicature particulière leur conférant un coefficient de flexibilité le long de l'axe principal du corps, offrant au moins une surface plane sensiblement parallèle à la base du corps et apte à être en contact avec un dissipateur thermique principal.

Dans un mode de réalisation de l'invention, l'ensemble de dissipation thermique peut être caractérisé en ce qu'un élément isolant intercalaire constitué d'un troisième matériau est disposé entre le dispositif de dissipation thermique et la carte de circuit électronique.

Dans un mode de réalisation de l'invention, l'ensemble de dissipation thermique peut être caractérisé en ce que la résine est coulée dans le corps à l'état liquide à une première température et durcit par polymérisation à une seconde température.

Dans un mode de réalisation de l'invention, l'ensemble de dissipation thermique peut être caractérisé en ce que le premier matériau est un alliage de cuivre-béryllium CuBe2.

Dans un mode de réalisation de l'invention, l'ensemble de dissipation thermique est caractérisé en ce que le corps est à section rectangulaire.

La présente invention a également pour objet un système comprenant une carte de circuit électronique comportant une pluralité de composants disposés en surface de la carte de circuit électronique, caractérisé en ce qu'au moins un des composants disposés en surface est associé à un ensemble de dissipation thermique selon un des modes de réalisation présentés.

La présente invention a également pour objet un système comprenant une carte de circuit électronique comportant une pluralité de composants disposés en surface de la carte de circuit électronique, caractérisé en ce qu'au moins un des composants disposés en surface est associé à un ensemble de dissipation thermique selon un des modes de réalisation présentés, les surfaces planes étant en contact avec la surface inférieure d'un dissipateur thermique principal.

D'autres caractéristiques et avantages de l'invention apparaîtront à la lecture de la description, donnée à titre d'exemple, faite en regard des dessins annexés qui représentent :
- la figure 1, une vue en perspective d'un dispositif de dissipation thermique, selon un mode de réalisation de l'invention ;
- la figure 2, une vue en perspective d'une pluralité de dispositifs de dissipation thermique disposés sur une carte de circuit électronique, selon un mode de réalisation de l'invention ;
- la figure 3, une vue en perspective d'une pluralité de dispositifs de dissipation thermique disposés entre une carte de circuit électronique et un dissipateur principal, selon un mode de réalisation de l'invention.

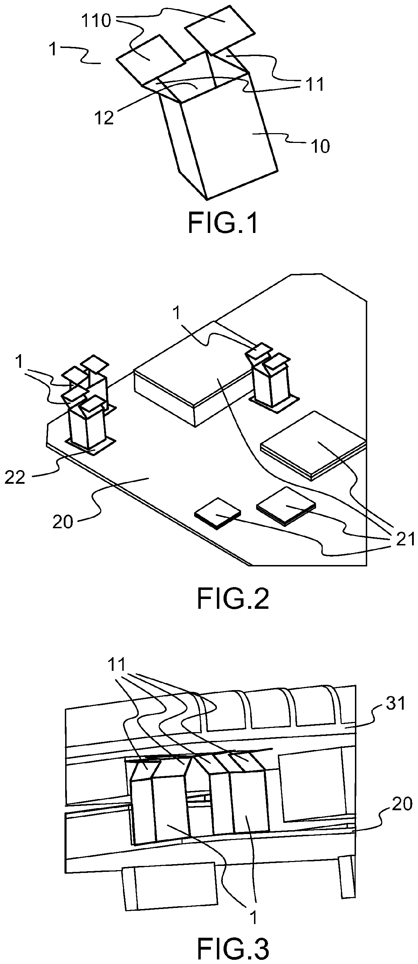

La figure 1 présente une vue en perspective illustrant un dispositif de dissipation thermique, selon un exemple de réalisation de la présente invention.

Le dispositif de dissipation thermique 1 peut comprendre un corps 10 dont au moins une partie du volume intérieur est emplie d'une résine 12. Avantageusement, ainsi que cela est illustré par la figure 1, le dispositif de dissipation thermique 1 peut comprendre au moins une patte en sa partie supérieure. Dans l'exemple illustré par la figure 1, deux pattes 11 sont formées au-dessus de la surface supérieure du corps 10 et offrent chacune une surface 110 sensiblement plane et parallèle à la base du corps 10.

Le corps 10 peut-être de forme cylindrique, ou bien encore de forme prismatique droite. Dans l'exemple illustré par la figure 1, le corps 10 est un prisme droit de section rectangulaire.

Le corps 10 peut être disposé de manière à inclure le composant, non représenté sur la figure, dont il est nécessaire de dissiper la chaleur produite et auquel doit être associé le dispositif de dissipation thermique 1. Le composant est également enfoui dans un volume de résine 12 compris à l'intérieur du corps 10. La résine 12 n'inclut pas nécessairement la totalité du composant, mais elle doit au moins inclure les parties chaudes du composant.

Le corps 10 est réalisé en un premier matériau, par exemple métallique, offrant une bonne conduction de la chaleur. Le premier matériau doit en outre offrir une rigidité suffisante, afin d'assurer un bon maintien de la résine 12 et du composant que celle-ci englobe. Le premier matériau doit également offrir de bonnes propriétés en termes d'élasticité. En effet, les pattes 11 peuvent être destinées à être en contact avec un élément tel qu'un couvercle ou un dissipateur thermique principal, ainsi que cela est explicité en détails ci-après, en référence à la figure 3.

Les pattes 11 peuvent notamment être formées dans un même bloc avec le corps 10. Par exemple par un pliage réalisé sur des excroissances du corps 10. Dans l'exemple illustré par la figure, le corps 10 peut être de forme prismatique droite à section rectangulaire. Des excroissances peuvent être réalisées sur deux faces verticales opposées du corps 10. Deux plicatures peuvent alors permettre de former les surfaces planes 110 précitées, tout en conférant aux pattes 11 des propriétés d'élasticité, notamment le long de l'axe principal du corps 10. Le premier matériau peut par exemple être un alliage de cuivre Béryllium CuBe2, offrant un bon compromis des caractéristiques précédemment citées.

Avantageusement, il est possible, pour des raisons d'ordre pratique, de former les surfaces planes 110 de manière à ce que le plan les contenant forme avec le plan de la base du corps 10, un angle non nul, les extrémités libres des surfaces planes 110 étant les plus éloignées de la base du corps 10. De la sorte, il est certain qu'une fois le couvercle ou le dissipateur thermique principal disposé sur le dessus des surfaces planes 110, le contact soit réparti sur la totalité de l'aire des surfaces planes 110.

La résine 12 est réalisée en un deuxième matériau, par exemple de type polymère. Le deuxième matériau doit conférer à la résine 12 de très bonnes caractéristiques en termes de conductivité thermique. Egalement, le deuxième matériau doit être électriquement isolant. Par exemple, le deuxième matériau peut être choisi pour offrir une conductivité thermique d'une manière typique supérieure à 1 W.m⁻¹.K⁻¹. Avantageusement, il est possible, dans un mode de réalisation de l'invention, de procéder au remplissage du corps 10 par la résine 12, lorsque la résine 12 est en phase liquide, puis de procéder ensuite à la polymérisation de la résine 12 : le corps 10 agit de la sorte comme un coffrage destinée à contenir la résine 12 qui y est coulée. Ainsi le deuxième matériau peut être fluide au moment de la coulée de la résine 12, puis solide après polymérisation. Il est par exemple possible d'utiliser une résine bi-composante, constituée d'un premier composé A et d'un second composé B, le composé B étant un catalyseur, ajouté de manière à déclencher la polymérisation de la résine 12. Le composé A de la résine 12 peut par exemple être préchauffée à une température prédéterminée, dont la valeur soit compatible de la plage d'utilisation du composant, typiquement à 40°C, avant mélange avec le composé B. En outre, le deuxième matériau choisi pour la résine 12 doit lui conférer une résistance aux températures d'utilisation prévues, c'est-à-dire des températures s'étendant de manière typique au moins dans un intervalle compris entre -40°C et +85°C. Le deuxième matériau peut par exemple être une résine bi-composante de type epoxy.

Avantageusement, la résine 12 à l'état liquide, doit offrir un coefficient de viscosité tel que celle-ci ne soit pas trop fluide, afin de limiter les risques d'écoulement de la résine hors du corps 10. Egalement, la résine 12 à l'état solide, c'est-à-dire après polymérisation, doit être suffisamment dure pour assurer un bon maintien au dispositif de dissipation thermique 1 et au composant qu'il contient.

Un avantage procuré par la présente invention, est qu'un dispositif de dissipation thermique 1 peut être adjoint à un ou plusieurs composants équipant une carte électronique existante, par exemple une carte électronique du commerce, mais destinée initialement à un refroidissement par ventilateur.

La figure 2 présente une vue en perspective illustrant une pluralité de dispositifs de dissipation thermique disposés sur une carte de circuit électronique, selon un mode de réalisation de l'invention.

Une carte de circuit électronique 20, par exemple de type PCB, comprend notamment une pluralité de composants 21 disposés en surface de celle-ci. La carte de circuit électronique 20 comprend en outre une pluralité - quatre dans l'exemple de la figure - de composants associés à des dispositifs de dissipation thermique 1, en référence à la figure 1 décrite ci-dessus. Chaque dispositif de dissipation thermique 1 est disposé au-dessus de la carte de circuit électronique 20, de manière sensiblement verticale et à englober le composant auquel il est associé. Avantageusement, un élément isolant intercalaire 22 peut être disposé entre la surface de la carte de circuit électronique 20 et le dispositif de dissipation thermique 1. L'élément isolant intercalaire 22 permet une isolation électrique entre la carte de circuit électronique 20 et le corps du dispositif de dissipation thermique. Le troisième matériau doit ainsi présenter des caractéristiques de souplesse afin que la répartition de l'élément isolant intercalaire 22 sous le corps du dispositif de dissipation thermique confère une étanchéité vis-à-vis de l'écoulement de la résine. Le troisième matériau doit en outre présenter des propriétés d'isolation électrique. Le troisième matériau peut ainsi, par exemple, être une gomme silicone, ou un mélange de gomme silicone et de fibres de verre, présentée par exemple sous la forme de feuilles d'une épaisseur typique de l'ordre de 100 µm.

L'élément isolant intercalaire 22 permet également d'éviter que la résine destinée à être contenue dans le corps du dispositif de dissipation thermique 1 ne s'écoule lors du remplissage de ce dernier ; elle permet également d'envisager la possibilité de dessouder le composant, par exemple en cas de panne de celui-ci. En effet, la résine est particulièrement attachée par collage à la carte de circuit électronique 20 lorsque celle-ci est polymérisée. L'élément isolant intercalaire 22 permet alors de minimiser la surface de résine en contact avec la carte de circuit électronique 20, facilitant ainsi le décollage de l'ensemble composant - dispositif de dissipation thermique, si cela doit s'avérer nécessaire au cours de la fabrication ou bien de la maintenance du système incluant ces éléments.

La figure 3 présente une vue en perspective d'une pluralité de dispositifs de dissipation thermique disposés entre une carte de circuit électronique et un dissipateur principal, selon un mode de réalisation de l'invention.

Dans l'exemple de la figure 3, deux dispositifs de dissipation thermique 1 sont disposés autour de composants montés sur la carte de circuit électronique 20, et dont il est nécessaire de dissiper la chaleur. L'exemple illustré par la figure 3 présente une configuration similaire à la configuration décrite ci-dessus en référence à la figure 2.

Il est possible de disposer un dissipateur thermique principal 31 permettant de dissiper la chaleur produite par une pluralité de composants montés sur la carte de circuit électronique 20, voire par l'ensemble de ceux-ci. Le dissipateur thermique principal 31 peut par exemple se présenter sous la forme d'un radiateur métallique muni d'ailettes. Les pattes 11 disposées sur les dispositifs de dissipation thermique 1, et notamment les surfaces planes 110 ménagées sur les pattes 11, peuvent avantageusement être en contact avec la surface inférieure du dissipateur thermique principal 31. Les pattes 11, se comportant comme des lames-ressorts, permettent notamment d'assurer un contact permanent entre les surfaces planes 110 et le dissipateur thermique principal 31. Il est à noter que le coefficient de flexibilité des pattes 11 peut être ajusté selon les besoins, via une modification d'un ou plusieurs paramètres parmi la nature du premier matériau constituant le corps, l'épaisseur des pattes, la longueur des pattes, le type de plicature formant les pattes et les surfaces planes. Dans une telle configuration, la chaleur suit un cheminement optimal, partant du composant, se dissipant alors dans la résine, puis dans le corps du dispositif de dissipation thermique 1, les pattes 11 et enfin le dissipateur thermique principal 31. Il est bien sûr nécessaire que les différents dispositifs de dissipation thermique 1 soient dimensionnés de manière à ce que l'ensemble des surfaces planes 110 soit sensiblement compris dans un même plan, sensiblement parallèle au plan contenant la surface de la carte de circuit électronique 20.

Dans un mode alternatif de réalisation, il est possible de fixer le dissipateur thermique principal 31 aux pattes 11, par des techniques de fixation en elles-mêmes connues de l'état de la technique, telles que des techniques de soudure ou encore de collage. Le système ainsi constitué présente alors l'avantage que les chocs et vibrations thermiques peuvent être amortis grâce aux propriétés d'élasticité conférées par les pattes 11.

Il est à noter que la surface d'échange de chaleur entre les composants et la résine est identique à celle qu'il y aurait entre les composants et l'air en l'absence de résine. Cependant, le coefficient de conductivité thermique de la résine est bien plus élevé que celui de l'air ; par conséquent la chaleur peut être efficacement conduite vers le corps du dispositif de dissipation thermique 1, qui est lui-même relié au dissipateur thermique principal 31.

## Revendications

1. Ensemble de dissipation thermique (1) pour un composant monté sur une carte de circuit électronique (20), comprenant un dispositif de dissipation thermique, dans lequel :
• le dispositif de dissipation thermique est un corps (10) creux, de forme cylindrique ou prismatique droite, constitué d'un premier matériau, disposé verticalement au-dessus de la carte de circuit électronique (20), le volume utile du corps cylindrique étant apte à inclure au moins le composant,
• le dispositif de dissipation thermique contient une résine (12) constituée d'un deuxième matériau, ayant une conductivité thermique supérieure à 1W.m⁻¹.K⁻¹ et emplissant au moins partiellement le volume intérieur du corps (10) formant coffrage ledit composant étant enfoui au moins partiellement dans le volume de la résine,
**caractérisé en ce que** :
• le corps (10) comprend au moins deux pattes (11) en sa partie supérieure, lesdites deux pattes étant formées par des excroissances sur deux faces opposées du corps (10), lesdites deux pattes (11) comprenant une plicature particulière leur conférant un coefficient de flexibilité le long de l'axe principal du corps, offrant une surface plane (110) sensiblement parallèle à la base du corps et apte à être en contact avec un dissipateur thermique principal (31).

2. Ensemble de dissipation thermique (1) selon la revendication 1, **caractérisé en ce qu'**un élément isolant intercalaire (22) constitué d'un troisième matériau est disposé entre le dispositif de dissipation thermique (1) et la carte de circuit électronique (20).

3. Ensemble de dissipation thermique (1) selon l'une quelconque des revendications précédentes, **caractérisé en ce que** la résine (12) est coulée dans le corps à l'état liquide à une première température et durcit par polymérisation à une seconde température.

4. Ensemble de dissipation thermique (1) selon l'une quelconque des revendications précédentes, **caractérisé en ce que** le premier matériau est un alliage de cuivre-béryllium CuBe2.

5. Ensemble de dissipation thermique (1) selon la revendication 1, **caractérisé en ce que** le corps (10) est à section rectangulaire.

6. Système comprenant une carte de circuit électronique (20) comportant une pluralité de composants (21) disposés en surface de la carte de circuit électronique (20), **caractérisé en ce qu'**au moins un des composants disposés en surface est associé à un ensemble de dissipation thermique selon l'une quelconque des revendications précédentes.

7. Système comprenant une carte de circuit électronique (20) comportant une pluralité de composants (21) disposés en surface de la carte de circuit électronique (20), **caractérisé en ce qu'**au moins un des composants disposés en surface est associé à un ensemble de dissipation thermique selon l'une quelconque des revendications 1 à 5, les surfaces planes (110) étant en contact avec la surface inférieure d'un dissipateur thermique principal (31).

## Patentansprüche

1. Wärmeableitungseinheit (1) für eine Komponente, die auf einer elektronischen Schaltungskarte (20) montiert ist, die eine Wärmeableitungsvorrichtung umfasst, bei der:
• die Wärmeableitungsvorrichtung ein Hohlkörper (10) von zylindrischer oder gerader prismatischer Form ist, gebildet aus einem ersten Material, vertikal über der elektronischen Schaltungskarte (20) angeordnet, wobei das Nutzvolumen des zylindrischen Körpers so ausgelegt ist, dass es mindestens die Komponente aufnehmen kann,
• die Wärmeableitungsvorrichtung ein Harz (12) bestehend aus einem zweiten Material mit einer Wärmeleitfähigkeit von mehr als 1W.m⁻¹.K⁻¹ enthält, das das Innenvolumen des Körpers (10) mindestens teilweise ausfüllt und eine Schale bildet, wobei die Komponente mindestens teilweise in dem Volumen des Harzes eingebettet ist, **dadurch gekennzeichnet, dass**:
• der Körper (10) mindestens zwei Laschen (11) im oberen Teil umfasst, wobei die zwei Laschen durch Vorsprünge auf den beiden gegenüberliegenden Flächen des Körpers (10) gebildet werden, wobei die zwei Laschen (11) eine besondere Falz aufweisen, die ihr einen Flexibilitätskoeffizienten entlang der Hauptachse des Körpers verleihen, sodass eine ebene Fläche (110) entsteht, die im Wesentlichen parallel zur Basis des Körpers ist und mit einem Hauptwärmeableiter (31) in Kontakt kommen kann. •

2. Wärmeableitungseinheit (1) nach Anspruch 1, **dadurch gekennzeichnet, dass** ein aus einem dritten Material gebildetes Isolierzwischenelement (22) zwischen der Wärmeableitungsvorrichtung (1) und der elektronischen Schaltungskarte (20) angeordnet ist.

3. Wärmeableitungseinheit (1) nach einem der vorherigen Ansprüche, **dadurch gekennzeichnet, dass** das Harz (12) im flüssigen Zustand bei einer ersten Temperatur in den Körper gegossen wird und durch Polymerisation auf einer zweiten Temperatur härtet.

4. Wärmeableitungseinheit (1) nach einem der vorherigen Ansprüche, **dadurch gekennzeichnet, dass** das erste Material eine Kupfer-Beryllium-Legierung CuBe2 ist.

5. Wärmeableitungseinheit (1) nach Anspruch 1, **dadurch gekennzeichnet, dass** das Gehäuse (10) einen rechteckigen Querschnitt hat.

6. System, das eine elektronische Schaltungskarte (20) umfasst, die mehrere Komponenten (21) umfasst, die auf der Oberfläche der elektronischen Schaltungskarte (20) angeordnet sind, **dadurch gekennzeichnet, dass** mindestens eine der auf der Oberfläche angeordneten Komponenten mit einer Wärmeableitungseinheit nach einem der vorherigen Ansprüche assoziiert ist.

7. System, das eine elektronische Schaltungskarte (20) umfasst, die mehrere Komponenten (21) umfasst, die auf der Oberfläche der elektronischen Schaltungskarte (20) angeordnet sind, **dadurch gekennzeichnet, dass** mindestens eine der auf der Oberfläche angeordneten Komponenten mit einer Wärmeableitungseinheit nach einem der Ansprüche 1 bis 5 assoziiert ist, wobei die ebenen Flächen (110) mit der Innenfläche eines Hauptwärmeableiters (31) in Kontakt sind.

## Claims

1. Heat sinking assembly (1) for a component mounted on an electronic circuit board (20), comprising a heat sinking device, in which:
• the heat sinking device is a hollow body (10), of cylindrical or straight prismatic form, consisting of a first material, arranged vertically on top of the electronic circuit board (20), the useful volume of the cylindrical body being able to include at least the component,
• the heat sinking device includes a resin (12) consisting of a second material having a thermal conductivity greater than 1 W.m⁻¹.K⁻¹ and, at least partially filling the internal volume of the body (10) forming a shuttering said component being at least partially buried in the volume of resin,
**characterized in that**:
• the body (10) comprises at least two tabs (11) in its top portion, said two tabs being formed by protuberances on two opposite faces of the body (10), said two tabs (11) comprising a particular fold line conferring on them a coefficient of flexibility along the main axis of the body, offering one planar surface (110) substantially parallel to the base of the body and able to be in contact with a main heat sink (31).

2. Heat sinking assembly (1) according to Claim 1, **characterized in that** an insulating separator element (22) consisting of a third material is arranged between the heat sinking device (1) and the electronic circuit board (20).

3. Heat sinking assembly (1) according to any one of the preceding claims, **characterized in that** the resin (12) is poured into the body in the liquid state at a first temperature and hardens by polymerization at a second temperature.

4. Heat sinking assembly (1) according to any one of the preceding claims, **characterized in that** the first material is a copper-beryllium alloy CuBe2.

5. Heat sinking assembly (1) according to Claim 3, **characterized in that** the body (10) is of rectangular section.

6. System comprising an electronic circuit board (20) having a plurality of components (21) arranged on the surface of the electronic circuit board (20), **characterized in that** at least one of the components arranged on the surface is associated with a heat sinking assembly according to any one of the preceding claims.

7. System comprising an electronic circuit board (20) having a plurality of components (21) arranged on the surface of the electronic circuit board (20), **characterized in that** at least one of the components arranged on the surface is associated with a heat sinking assembly according to any one of Claims 1 to 5, the planar surfaces (110) being in contact with the bottom surface of a main heat sink (31).
